(19) Europäisches Patentamt
European Patent Office
Office européen des brevets

(11) **EP 2 514 094 B1**

(12) **FASCICULE DE BREVET EUROPEEN**

(45) Date de publication et mention de la délivrance du brevet:
**03.05.2017 Bulletin 2017/18**

(51) Int Cl.:
*H03H 9/02* *(2006.01)*     *G04B 17/06* *(2006.01)*
*G04B 17/22* *(2006.01)*     *H03H 3/007* *(2006.01)*

(21) Numéro de dépôt: **10781637.3**

(22) Date de dépôt: **10.11.2010**

(86) Numéro de dépôt international:
**PCT/EP2010/067181**

(87) Numéro de publication internationale:
**WO 2011/072960 (23.06.2011 Gazette 2011/25)**

(54) **RÉSONATEUR THERMOCOMPENSE AU MOINS AUX PREMIER ET SECOND ORDRES**

THERMOKOMPENSIERTER RESONATOR MINDESTENS ERSTEN UND ZWEITEN GRADES

RESONATOR THERMOCOMPENSATED AT LEAST TO THE FIRST AND SECOND ORDERS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.12.2009 EP 09179323**

(43) Date de publication de la demande:
**24.10.2012 Bulletin 2012/43**

(73) Titulaire: **The Swatch Group Research and Development Ltd.**
**2074 Marin (CH)**

(72) Inventeurs:
• **HESSLER, Thierry**
**CH-2024 St-Aubin (CH)**
• **CONUS, Thierry**
**CH-2543 Lengnau (CH)**
• **TRÜMPY, Kaspar**
**CH-4500 Soleures (CH)**

(74) Mandataire: **Goulette, Ludivine et al**
**ICB**
**Ingénieurs Conseils en Brevets SA**
**Faubourg de l'Hôpital 3**
**2001 Neuchâtel (CH)**

(56) Documents cités:
EP-A1- 1 422 436       WO-A1-2008/043727
WO-A2-2007/072409     US-A1- 2005 195 050

• NAKAGAWA Y: "Control of second order temperature coefficient of SAW propagating in two thin film layers", ULTRASONICS SYMPOSIUM, 1993. PROCEEDINGS., IEEE 1993 BALTIMORE, MD, USA 31 OCT.-3 NOV. 1993, NEW YORK, NY, USA,IEEE LNKD-DOI:10.1109/ULTSYM.1993.339570, 31 octobre 1993 (1993-10-31), pages 287-290, XP010115030, ISBN: 978-0-7803-1278-4
• SCHOEN F ET AL: "Temperature Compensation in Silicon-Based Micro-Electromechanical Resonators", MICRO ELECTRO MECHANICAL SYSTEMS, 2009. MEMS 2009. IEEE 22ND INTERNATIONAL CONFERENCE ON, IEEE, PISCATAWAY, NJ, USA, 25 janvier 2009 (2009-01-25), pages 884-887, XP031444436, ISBN: 978-1-4244-2977-6
• MELAMUD R ET AL: "Temperature-Insensitive Composite Micromechanical Resonators", JOURNAL OF MICROELECTROMECHANICAL SYSTEMS, IEEE SERVICE CENTER, PISCATAWAY, NJ, US, vol. 18, no. 6, 1 décembre 2009 (2009-12-01), pages 1409-1419, XP011283695, ISSN: 1057-7157, DOI: DOI:10.1109/JMEMS.2009.2030074
• BHATTACHARJEE K ET AL: "Temperature Compensation in SAW Filters by Tri-Layer Wafer Engineering", FREQUENCY CONTROL SYMPOSIUM, 2007 JOINT WITH THE 21ST EUROPEAN FREQUEN CY AND TIME FORUM. IEEE INTERNATIONAL, IEEE, PI, 1 mai 2007 (2007-05-01), pages 189-193, XP031137950, ISBN: 978-1-4244-0646-3

**EP 2 514 094 B1**

**Description**

<u>Domaine de l'invention</u>

L'invention se rapporte à un résonateur thermocompensé du type balancier-spiral, MEMS ou diapason permettant de fabriquer une base de temps ou de fréquence dont les coefficients thermiques sont sensiblement nuls au moins aux premier et deuxième ordres.

<u>Arrière plan de l'invention</u>

Le document EP 1 422 436 divulgue un spiral formé en silicium et recouvert de dioxyde de silicium afin de rendre le coefficient thermique sensiblement nul autour des températures de procédure COSC, c'est-à-dire entre +8 et +38 °C. De même, le document WO 2008-043727 divulgue un résonateur MEMS qui possède des qualités similaires de faible dérive de son module d'Young dans la même plage de température. Le document XP10115030 divulgue un substrat pour un dispositif à ondes acoustiques de surface ayant les coefficients thermiques de temps de retard aux premier et deuxième ordres sensiblement nuls. Le substrat comporte du quartz avec deux revêtements en $Ta_2O_5$ et ZnO dont les coefficients thermiques du temps de retard au deuxième ordre sont de signe opposé. Les coefficients thermiques du temps de retard aux premier et deuxième ordres du substrat sont contrôlés en ajustant les épaisseurs des revêtements. Le document WO 2007-072409 divulgue un résonateur thermocompensé du type MEMS comportant un corps utilisé en déformation, l'âme du corps comportant un premier matériau, le corps comportant un premier et un deuxième revêtements respectivement en un deuxième et un troisième matériaux, les coefficients thermoélastiques de chaque matériau étant différents. Les épaisseurs des revêtements sont ajustées pour rendre le coefficient thermoélastique du résonateur au premier ordre sensiblement nul. Cependant la dérive de la fréquence même uniquement au deuxième ordre des divulgations ci-dessus peut nécessiter des corrections complexes selon les applications. Par exemple, pour que des montres électroniques puissent être certifiées COSC une correction électronique basée sur une mesure de la température doit être effectuée.

<u>Résumé de l'invention</u>

Le but de la présente invention est de pallier tout ou partie les inconvénients cités précédemment en proposant un résonateur compensé thermiquement au moins aux premier et deuxième ordres.
A cet effet, l'invention se rapporte, selon un premier mode de réalisation, à un résonateur thermocompensé du type diapason comportant un corps formé d'au moins deux barreaux montés symétriquement et utilisé en déformation, l'âme du corps comportant un premier matériau, le corps comportant au moins un premier et un deuxième revêtements respectivement en un deuxième et un troisième matériaux, les coefficients thermoélastiques de chaque matériau étant différents, chaque épaisseur desdits au moins un premier et un deuxième revêtements étant ajustée pour permettre des coefficients thermiques de fréquence du résonateur aux premier et deuxième ordres sensiblement nuls.
Selon un deuxième mode de réalisation, l'invention se rapporte à un résonateur thermocompensé du type balancier-spiral comportant un corps comprenant un barreau enroulé sur lui-même en formant un spiral, couplé avec un volant d'inertie et utilisé en déformation, l'âme du corps comportant un premier matériau, le corps comportant au moins un premier et un deuxième revêtements respectivement en un deuxième et un troisième matériaux, les coefficients thermoélastiques de chaque matériau étant différents, chaque épaisseur desdits au moins un premier et un deuxième revêtements étant ajustée pour permettre des coefficients thermiques de fréquence du résonateur aux premier et deuxième ordres sensiblement nuls.
Enfin, selon un troisième mode de réalisation, l'invention se rapporte à un résonateur thermocompensé du type MEMS comportant un corps utilisé en déformation, l'âme du corps comportant un premier matériau, le corps comportant au moins un premier et un deuxième revêtements respectivement en un deuxième et un troisième matériaux, les coefficients thermoélastiques de chaque matériau étant différents, chaque épaisseur desdits au moins un premier et un deuxième revêtements étant ajustée pour permettre des coefficients thermiques de fréquence du résonateur aux premier et deuxième ordres sensiblement nuls.
Avantageusement selon l'invention, le corps du résonateur utilisé en déformation comporte autant de revêtement que d'ordre du coefficient thermique à compenser. Ainsi, suivant les grandeurs et les signes de chaque ordre des matériaux de l'âme et de chaque revêtement, un calcul de chaque épaisseur est effectué afin de compenser chaque ordre.
Conformément à d'autres caractéristiques avantageuses de l'invention :

- le corps comporte un troisième revêtement en un quatrième matériau dont les coefficients thermoélastiques de chaque matériau sont différents, chaque épaisseur desdits trois revêtements étant ajustée pour permettre audit résonateur d'avoir des coefficients thermiques aux premier, deuxième et troisième ordres sensiblement nuls ;

- l'âme du corps comporte des coefficients thermoélastiques qui sont négatifs aux premier et deuxième ordres comme du silicium monocristallin ;
- le corps comporte une section sensiblement en forme d'un quadrilatère dont les faces sont identiques deux à deux ou dont les faces sont entièrement revêtues ;
- le premier revêtement comporte des coefficients thermoélastiques qui sont positif au premier ordre et négatif du deuxième ordre comme du dioxyde de silicium ;
- le deuxième revêtement comporte des coefficients thermoélastiques qui sont positifs au deuxième ordre et au premier ordre comme du dioxyde de germanium ou comporte un coefficient thermique qui est négatif au premier ordre.

Enfin, l'invention se rapporte également à une base de temps ou de fréquence, comme par exemple une pièce d'horlogerie, caractérisée en ce qu'elle comporte au moins un résonateur conforme à l'une des variantes précédentes.

Description sommaire des dessins

D'autres particularités et avantages ressortiront clairement de la description qui en est faite ci-après, à titre indicatif et nullement limitatif, en référence aux dessins annexés, dans lesquels :

- la figure 1 est une représentation générale en perspective d'un ressort-spiral ;
- la figure 2 est une section représentative du ressort-spiral de la figure 1 ;
- la figure 3 est une représentation de plusieurs modes de réalisation selon l'invention ;
- la figure 4 est un graphique représentant les modules élastiques de chaque matériau selon un premier mode de réalisation de l'invention ;
- la figure 5 est un graphique représentant les modules élastiques de chaque matériau selon un deuxième mode de réalisation de l'invention ;
- la figure 6 est un graphique représentant l'absence de variation de fréquence d'un résonateur selon l'invention ;
- la figure 7 est un graphique représentant les variations des premier et deuxième ordres du coefficient thermique d'un balancier-spiral de silicium enrobé de dioxyde de silicium ;
- la figure 8 est un graphique représentant les variations des premier et deuxième ordres du coefficient thermique d'un balancier-spiral de silicium enrobé de dioxyde de germanium ;
- la figure 9 est un graphique représentant les variations des premier et deuxième ordres du coefficient thermique d'un balancier-spiral de silicium enrobé de dioxyde de silicium et de dioxyde de germanium.

Description détaillée des modes de réalisation préférés

Comme expliqué ci-dessus, l'invention se rapporte à un résonateur qui peut être du type balancier-spiral, diapason ou plus généralement un résonateur du type MEMS (abréviation provenant des termes anglais « Micro Electro Mechanical System »). Afin d'apporter une explication plus simple de l'invention, seule l'application à un balancier-spiral est présentée ci-dessous. Cependant, d'autres applications de résonateur comme celles ci-dessus seront réalisables pour un homme du métier sans difficultés excessives à partir de l'enseignement ci-dessous.

De même, l'explication est portée sur une âme du corps, dans notre exemple un spiral, formé à partir de silicium monocristallin. Cependant, le matériau de l'âme n'est pas limité à du silicium monocristallin mais peut s'élargir à différents types de matériaux comme, par exemple, du polysilicium, du verre, du nitrure, du diamant, du quartz monocristallin ou du métal.

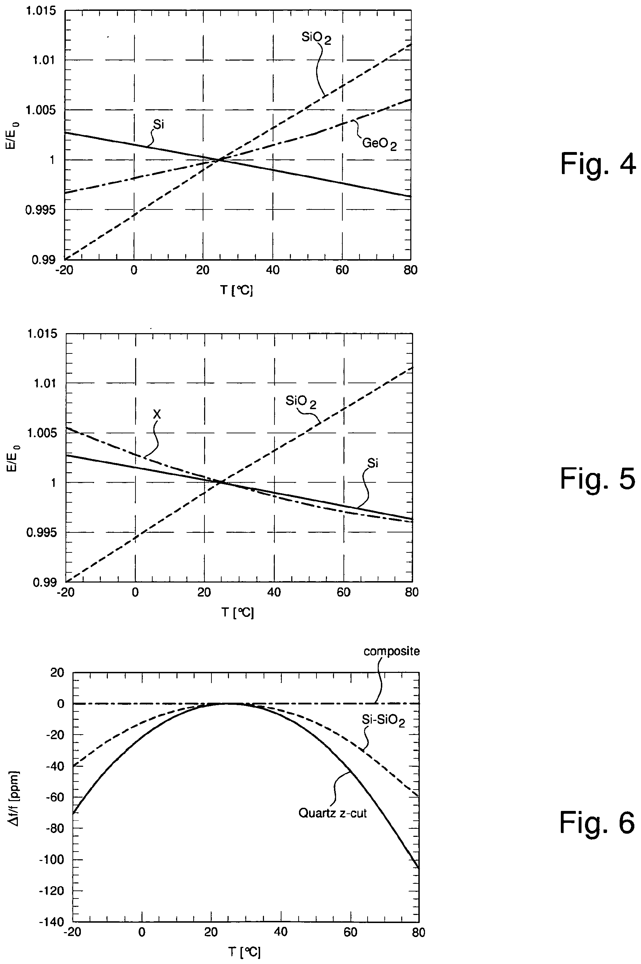

Dans le graphique à la figure 6, on peut voir la caractérisation de dérive de la fréquence pour des résonateurs actuels en fonction de la température. Une première courbe en trait plein intitulée « Quartz-z-cut » montre la dérive fréquentielle d'un diapason 32 kHz en quartz monocristallin réalisé dans une coupe z légèrement tournée. Une deuxième courbe en traits interrompus courts intitulé « Si-SiO$_2$ » montre la dérive fréquentielle d'un résonateur MEMS en silicium revêtu de dioxyde de silicium.

Pour ces deux courbes, on voit que la dérive est non nulle sur une large gamme de températures notamment entre -20 et 80°C. Cette dérive fréquentielle est principalement liée à la variation du module d'Young en fonction de la température. Cependant, même faible entre 10 et 40°C, la dérive fréquentielle des deux exemples de fabrication actuelle peut nécessiter une correction extrinsèque au résonateur. C'est le cas par exemple d'une montre électronique qui contient un diapason en quartz corrigé électroniquement sur la base d'une mesure de la température de la montre, afin d'être certifiée COSC.

Ainsi, avantageusement, le but de l'invention est de proposer un résonateur dont la dérive fréquentielle en fonction de la température est encore minimisée comme montré par la courbe en traits interrompus courts et longs intitulé « composite » dont l'échelle est volontairement gardée identique par rapport aux deux autres courbes afin de montrer l'importante différence de la dérive. Plus précisément, le corps du résonateur, selon l'invention, comporte autant de revêtements que d'ordres du coefficient thermique à compenser.

Préférentiellement, le corps du résonateur comprend ainsi au moins deux revêtements et éventuellement un troisième si la compensation au deuxième ordre induit toujours une dérive fréquentielle inacceptable. Cependant, à partir du troisième ordre compensé, la dérive fréquentielle devient négligeable pour n'importe quel résonateur. Ainsi, suivant les grandeurs et les signes de chaque ordre des matériaux de l'âme et de chaque revêtement, un calcul de chaque épaisseur est effectué afin de compenser globalement chaque ordre.

A titre de définition, la variation relative de la fréquence du résonateur suit la relation suivante :

$$\frac{\Delta f}{f_0} = A + \alpha \cdot (T - T_0) + \beta \cdot (T - T_0)^2 + \gamma \cdot (T - T_0)^3$$

où

- $\frac{\Delta f}{f_0}$ est la variation relative de fréquence, exprimée en ppm ($10^{-6}$) ;
- A une constante qui dépend du point de référence, en ppm ;
- $T_0$ la température de référence, en °C ;
- $\alpha$ le coefficient thermique du premier ordre, exprimé en ppm. °C$^{-1}$ ;
- $\beta$ le coefficient thermique du deuxième ordre, exprimé en ppm. °C$^{-2}$ ;
- $\gamma$ le coefficient thermique du troisième ordre, exprimé en ppm. °C$^{-3}$.

De plus, le coefficient thermoélastique (CTE) représente la variation relative du module d'Young en fonction de la température. Les termes « $\alpha$ » et « $\beta$ » qui sont utilisés ci-dessous représentent ainsi respectivement les coefficients thermiques du premier et du deuxième ordre c'est-à-dire la variation relative de la fréquence du résonateur en fonction de la température. Les termes « $\alpha$ » et « $\beta$ » dépendent du coefficient thermoélastique du corps du résonateur et des coefficients de dilatation du corps. De plus, les termes « $\alpha$ » et « $\beta$ » prennent également en compte les coefficients propres à une éventuelle inertie séparée, telle que, par exemple, le balancier pour un résonateur balancier - spiral. Les oscillations de tout résonateur destiné à une base de temps ou de fréquence devant être entretenu, la dépendance thermique comprend également une contribution éventuelle du système d'entretien. Préférentiellement, le corps du résonateur est une âme 3 recouverte d'au moins deux revêtements 4, 5.

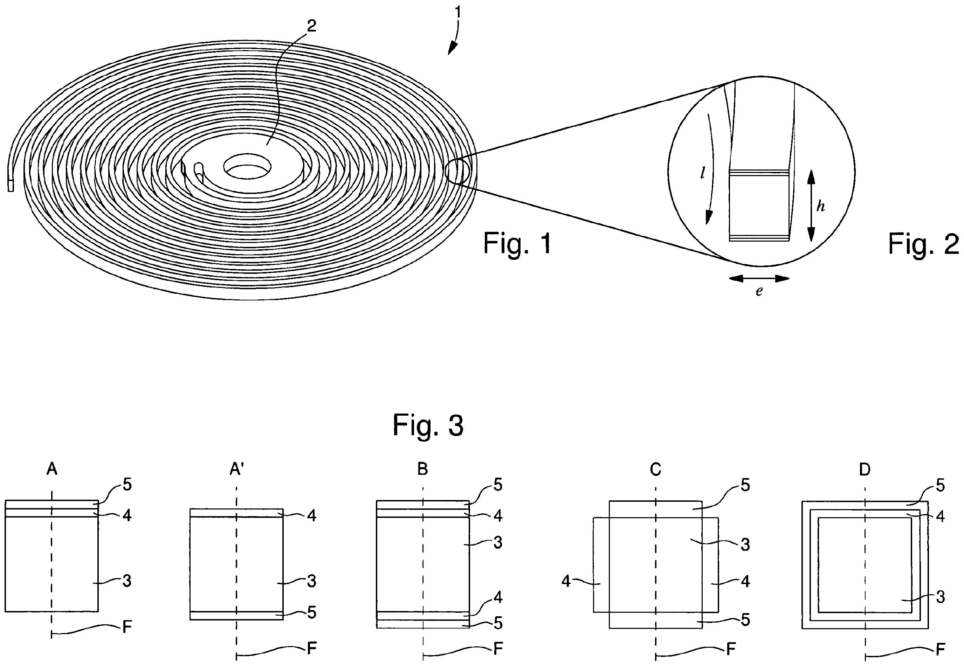

Dans l'exemple illustré aux figures 1 à 3, on peut voir un spiral 1 venu de forme avec sa virole 2 dont au moins les premier et deuxième ordres du coefficient thermique du corps sont compensés. La figure 2 propose une coupe du corps du spiral permettant de mieux voir sa section en forme de quadrilatère. Le corps peut ainsi être défini par sa longueur *l*, sa hauteur *h* et son épaisseur *e*. La figure 3 montre des alternatives possibles A, A', B, C et D sans être exhaustives. Bien évidemment, les revêtements 4 et 5 ne sont pas à l'échelle par rapport aux dimensions de l'âme 3, ceci afin de mieux montrer les localisations de chaque partie 3, 4 et 5.

Dans une première alternative A, une seule face de la section est recouverte successivement par le revêtement 4 puis par le revêtement 5. L'ordre d'empilement entre les revêtements 4 et 5 n'est pas fixé, c'est-à-dire que les revêtements 4 et 5 peuvent être intervertis. De plus, quand ce sont les faces parallèles au plan neutre F du barreau qui sont recouvertes cela modifie avec plus d'intensité la fréquence dudit résonateur que si le dépôt était effectué sur celles perpendiculaires au plan de flexion F. Bien entendu, il peut également être imaginé que chaque revêtement 4, 5 soit présent sur une face différente comme illustré à l'alternative A'.

Dans une deuxième alternative B ou C, la section du corps comporte des faces identiques deux à deux. Ainsi soit deux faces parallèles comportent les deux revêtements 4, 5 empilés sans ordre particulier, c'est-à-dire que les revêtements 4 et 5 peuvent être intervertis, comme dans l'exemple B, soit chacune des faces parallèles possèdent un des revêtements 4, 5 comme dans l'exemple C. Bien entendu, il peut également être imaginé qu'un revêtement 4 soit présent sur deux faces adjacentes et que les deux autres faces soient recouvertes par un revêtement 5.

Dans une troisième alternative D, la section du corps comporte des faces qui sont entièrement revêtues successivement par le revêtement 4 puis par le revêtement 5. L'ordre d'empilement entre les revêtements 4 et 5 n'a cependant ici pas non plus d'importance, c'est-à-dire que les revêtements 4 et 5 peuvent être intervertis.

Comme illustré à la figure 4, on peut voir un graphique représentant la dépendance thermique du module de Young de chaque matériau pour illustrer un mode de réalisation de l'invention qui utilise le silicium, le dioxyde de silicium et le dioxyde de germanium. Ainsi, le module d'Young du silicium diminue en augmentant la température quand les modules d'Young des deux autres matériaux croissent en augmentant la température. De plus, la croissance est plus marquée pour le dioxyde de silicium que pour le dioxyde de germanium entre les deux valeurs de température, c'est-à-dire entre -20°C et 80 °C.

En fait, le coefficient thermoélastique du silicium est négatif au premier et second ordre quand les coefficients thermoélastiques des deux autres matériaux sont positifs au premier ordre. Cependant, le coefficient thermoélastique au deuxième ordre est négatif pour le dioxyde de silicium alors qu'il est positif pour le dioxyde de germanium.

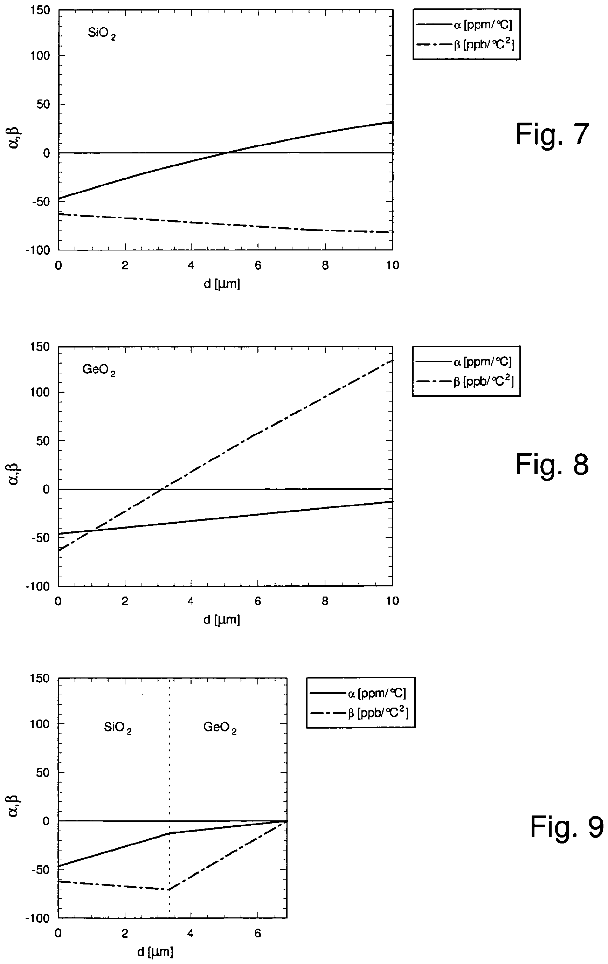

Cependant, cette interprétation de la figure 4 se focalise sur le coefficient thermoélastique des matériaux. Il est nécessaire de prendre encore en compte les coefficients de dilatations des matériaux et l'effet du système d'entretien des oscillations pour finalement obtenir les coefficients $\alpha$, $\beta$ de la modification de la fréquence du résonateur. Pour comprendre cette interprétation finale, ses deux coefficients sont représentés aux figures 7 et 8.

Ainsi, pour la figure 7, l'âme 3 comporte des coefficients thermoélastiques des premier et deuxième ordres qui sont négatifs, comme le silicium, et recouvert par un revêtement 4 qui comporte les coefficients thermoélastiques du premier ordre positif et du deuxième ordre négatif, comme le dioxyde de silicium. Sont également pris en compte, les coefficients de dilatation des matériaux, en particulier celui du balancier (18 ppm/°C). L'effet du système d'entretien des oscillations est ici négligé. On peut également voir à la figure 7 que les ordres $\alpha$ (trait continu) et $\beta$ (traits discontinus) ne sont pas à la même unité. On voit qu'à partir d'une certaine épaisseur de revêtement, le premier ordre $\alpha$ est compensé, c'est-à-dire croise la ligne 0, par contre, le deuxième ordre $\beta$ ne fait que diminuer par rapport au matériau de l'âme seul. On comprend donc que si le premier ordre $\alpha$ peut être compensé, tel n'est pas le cas du deuxième ordre $\beta$.

A la figure 8, l'âme 3 comporte des coefficients thermoélastiques des premier et deuxième ordres qui sont négatifs, comme le silicium, et recouvert par un revêtement 5 qui comporte des coefficients thermoélastiques des premier et deuxième ordres qui sont positifs, comme le dioxyde de germanium. Comme pour la figure 7, on peut voir à la figure 8 que les ordres $\alpha$ (trait continu) et $\beta$ (traits discontinus) ne sont pas à la même unité. On voit qu'à partir d'une faible épaisseur de revêtement, le deuxième ordre $\beta$ est compensé, c'est-à-dire croise la ligne 0, par contre, le premier ordre $\alpha$ est compensé à une plus forte épaisseur. Cependant, il est impossible que les deux ordres $\alpha$ et $\beta$ soient compensés avec une épaisseur d'un seul matériau.

Cela est dû aux différences de grandeurs des coefficients thermoélastiques à chaque ordre de chaque matériau. Ainsi, s'il semble illusoire de trouver un matériau pour le revêtement exactement « inverse » à celui de l'âme, ce qui permettrait de déposer une couche unique de compensation, l'invention propose, pour chaque ordre à compenser, d'ajouter un revêtement. Chaque revêtement n'est alors pas destiné à corriger « directement » un ordre mais permet d'affiner chacune des compensations.

A titre d'exemple, des calculs ont été représentés à la figure 9. Dans cet exemple, l'âme 3 comporte des coefficients thermoélastiques des premier et deuxième ordres qui sont négatifs, comme le silicium. L'âme 3 est recouverte par un premier revêtement 4 qui comporte des coefficients thermoélastiques du premier ordre positif et du deuxième ordre négatif, comme le dioxyde de silicium. Le premier revêtement 4 est lui-même recouvert par un deuxième revêtement 5 qui comporte un coefficient thermoélastique des premier et deuxième ordres qui sont positifs, comme le dioxyde de germanium.

Comme visible à la figure 9, on voit qu'il devient possible par calcul d'ajuster chaque épaisseur de revêtement 4, 5 afin que la compensation des ordres $\alpha$ et $\beta$ convergent sensiblement à la même épaisseur finale, c'est-à-dire que les deux courbes $\alpha$ et $\beta$ coupent la ligne 0 à la même épaisseur. Dans notre exemple de la figure 9, l'âme 3, le premier revêtement 4 et le deuxième revêtement 5 comportent ainsi des épaisseurs respectives d'environ 40, 3,5 et 3,6 microns.

Ainsi, suivant l'épaisseur de l'âme 3 voulue ou celle de la section finale voulue, il est possible d'offrir un résonateur dont la compensation thermique est très améliorée par rapport à celles « Quartz-z-cut » ou « Si-SiO$_2$ » représentées à la figure 6.

Bien entendu, la présente invention ne se limite pas à l'exemple illustré mais est susceptible de diverses variantes et modifications qui apparaîtront à l'homme de l'art. En particulier, d'autres matériaux pour l'âme 3 ou pour les revêtements 4, 5, etc. sont envisageables en obtenant une compensation thermique améliorée.

A titre d'exemple, il est fort probable qu'un matériau qui sera appelé X (comme les oxydes de zirconium ou d'hafnium stabilisés), qui comporte des coefficients thermoélastiques du premier ordre négatif (comme c'est le cas de la plupart des matériaux) et du deuxième ordre positif, puisse réaliser la compensation thermique. Cet exemple est illustré à la figure 5. On comprend donc que, pour ce type de matériau, le premier revêtement a nécessairement une épaisseur supérieure par rapport à celle du mode de réalisation de la figure 4.

## Revendications

1. Résonateur (1) thermocompensé du type diapason comportant un corps formé d'au moins deux barreaux montés symétriquement et utilisé en déformation, l'âme (3) du corps comportant un premier matériau, le corps comportant un premier revêtement (4) en un deuxième matériau **caractérisé en ce que** le corps comporte au moins un deuxième revêtement (5) en un troisième matériau, les coefficients thermoélastiques de chaque matériau étant différents, chaque épaisseur desdits au moins un premier et un deuxième revêtements étant ajustée pour permettre des coefficients thermiques de fréquence du résonateur (1) aux premier et deuxième ordres ($\alpha$, $\beta$) sensiblement nuls.

**2.** Résonateur (1) thermocompensé du type balancier-spiral comportant un corps comprenant un barreau enroulé sur lui-même en formant un spiral, couplé avec un volant d'inertie et utilisé en déformation, l'âme (3) du corps comportant un premier matériau, le corps comportant un premier revêtement (4) en un deuxième matériau **caractérisé en ce que** le corps comporte au moins un deuxième revêtement (5) en un troisième matériau, les coefficients thermoélastiques de chaque matériau étant différents, chaque épaisseur desdits au moins un premier et un deuxième revêtements étant ajustée pour permettre des coefficients thermiques de fréquence du résonateur (1) aux premier et deuxième ordres ($\alpha$, $\beta$) sensiblement nuls.

**3.** Résonateur (1) thermocompensé du type MEMS comportant un corps utilisé en déformation, l'âme (3) du corps comportant un premier matériau, le corps comportant au moins un premier et un deuxième revêtements (4, 5) respectivement en un deuxième et un troisième matériaux, les coefficients thermoélastiques de chaque matériau étant différents, **caractérisé en ce que** chaque épaisseur desdits au moins un premier et un deuxième revêtements est ajustée pour permettre des coefficients thermiques de fréquence du résonateur (1) aux premier et deuxième ordres ($\alpha$, $\beta$) sensiblement nuls.

**4.** Résonateur (1) selon la revendication 1, 2 ou 3, **caractérisé en ce que** le corps comporte un troisième revêtement en un quatrième matériau dont les coefficients thermoélastiques de chaque matériau sont différents, chaque épaisseur desdits trois revêtements étant ajustée pour permettre des coefficients thermiques du résonateur (1) aux premier, deuxième et troisième ordres ($\alpha$, $\beta$, $\gamma$) sensiblement nuls.

**5.** Résonateur (1) selon l'une des revendications précédentes, **caractérisé en ce que** l'âme (3) du corps comporte des coefficients thermoélastiques qui sont négatifs aux premier et deuxième ordres.

**6.** Résonateur (1) selon la revendication précédente, **caractérisé en ce que** l'âme (3) du corps comporte du silicium monocristallin.

**7.** Résonateur (1) selon l'une des revendications précédentes, **caractérisé en ce que** le corps comporte une section sensiblement en forme d'un quadrilatère dont les faces sont identiques deux à deux.

**8.** Résonateur (1) selon l'une des revendications 1 à 6, **caractérisé en ce que** le corps comporte une section sensiblement en forme d'un quadrilatère dont les faces sont entièrement revêtues.

**9.** Résonateur (1) selon l'une des revendications précédentes, **caractérisé en ce que** le premier revêtement (4) comporte des coefficients thermoélastiques qui sont positif au premier ordre et négatif au deuxième ordre.

**10.** Résonateur (1) selon la revendication précédente, **caractérisé en ce que** le premier revêtement (4) comporte du dioxyde de silicium.

**11.** Résonateur (1) selon la revendication 9 ou 10, **caractérisé en ce que** le deuxième revêtement (5) comporte un coefficient thermoélastique qui est positif au deuxième ordre.

**12.** Résonateur (1) selon la revendication précédente, **caractérisé en ce que** le deuxième revêtement (5) comporte un coefficient thermoélastique qui est positif au premier ordre.

**13.** Résonateur (1) selon la revendication précédente, **caractérisé en ce que** le deuxième revêtement (5) comporte du dioxyde de germanium.

**14.** Résonateur (1) selon la revendication 11, **caractérisé en ce que** le deuxième revêtement (5) comporte un coefficient thermoélastique qui est négatif au premier ordre.

**15.** Pièce d'horlogerie **caractérisée en ce qu'**elle comporte au moins un résonateur conforme à l'une des revendications précédentes.

**Patentansprüche**

**1.** Thermokompensierter Resonator (1) vom Stimmgabeltyp, umfassend einen Körper, der aus mindestens zwei symmetrisch angeordneten Stäben gebildet ist und verformend benutzt wird, wobei der Kern (3) des Körpers ein erstes Material umfasst und der Körper eine erste Auflage (4) aus einem zweiten Material umfasst, **dadurch gekennzeichnet, dass** der Körper mindestens eine zweite Auflage (5) aus einem dritten Material umfasst, wobei die thermoelastischen Koeffizienten jedes Materials unterschiedlich sind und die jeweilige Dicke der mindestens einen ersten und der mindestens einen zweiten Auflage so eingestellt ist, dass die thermischen Koeffizienten der Frequenz des Resonators (1) erster und zweiter Ordnung ($\alpha$, $\beta$) auf im Wesentlichen null einstellbar sind.

2. Thermokompensierter Resonator (1) vom Typ Unruh-Spiralfeder, umfassend einen Körper, der einen um sich selbst gewickelten, eine Spirale bildenden Stab aufweist, der mit einem Trägheitsschwungrad gekoppelt ist und verformend benutzt wird, wobei der Kern (3) des Körpers ein erstes Material umfasst und der Körper eine erste Auflage (4) aus einem zweiten Material umfasst, **dadurch gekennzeichnet, dass** der Körper mindestens eine zweite Auflage (5) aus einem dritten Material umfasst, wobei die thermoelastischen Koeffizienten jedes Materials unterschiedlich sind und die jeweilige Dicke der mindestens einen ersten und der mindestens einen zweiten Auflage so eingestellt ist, dass die thermischen Koeffizienten der Frequenz des Resonators (1) erster und zweiter Ordnung ($\alpha$, $\beta$) auf im Wesentlichen null einstellbar sind.

3. Thermokompensierter Resonator (1) des MEMS-Typs, umfassend einen verformend benutzten Körper, wobei der Kern (3) des Körpers ein erstes Material umfasst und der Körper mindestens eine erste und eine zweite Auflage (4, 5) jeweils aus einem zweiten und einem dritten Material umfasst, wobei die thermoelastischen Koeffizienten jedes Materials unterschiedlich sind, **dadurch gekennzeichnet, dass** die jeweilige Dicke der mindestens einen ersten und der mindestens einen zweiten Auflage so eingestellt ist, dass die thermischen Koeffizienten der Frequenz des Resonators (1) erster und zweiter Ordnung ($\alpha$, $\beta$) auf im Wesentlichen null einstellbar sind.

4. Resonator (1) nach Anspruch 1, 2 oder 3, **dadurch gekennzeichnet, dass** der Körper eine dritte Auflage aus einem vierten Material umfasst, wobei die thermoelastischen Koeffizienten jedes Materials unterschiedlich sind und jede Dicke der drei Auflagen so eingestellt ist, dass die thermischen Koeffizienten des Resonators (1) erster, zweiter und dritter Ordnung ($\alpha$, $\beta$, $\gamma$) auf im Wesentlichen null einstellbar sind.

5. Resonator (1) nach einem der vorhergehenden Ansprüche, **dadurch gekennzeichnet, dass** der Kern (3) des Körpers thermoelastische Koeffizienten aufweist, die in erster und zweiter Ordnung negativ sind.

6. Resonator (1) nach dem vorhergehenden Anspruch, **dadurch gekennzeichnet, dass** der Kern (3) des Körpers monokristallines Silicium enthält.

7. Resonator (1) nach einem der vorhergehenden Ansprüche, **dadurch gekennzeichnet, dass** der Körper einen im Wesentlichen viereckigen Querschnitt aufweist, dessen Seiten paarweise gleich sind.

8. Resonator (1) nach einem der Ansprüche 1 bis 6, **dadurch gekennzeichnet, dass** der Körper einen im Wesentlichen viereckigen Querschnitt aufweist, dessen Seiten vollständig ummantelt sind.

9. Resonator (1) nach einem der vorhergehenden Ansprüche, **dadurch gekennzeichnet, dass** die erste Auflage (4) thermoelastische Koeffizienten aufweist, die in erster Ordnung positiv und in zweiter Ordnung negativ sind.

10. Resonator (1) nach dem vorhergehenden Anspruch, **dadurch gekennzeichnet, dass** die erste Auflage (4) Siliciumdioxid enthält.

11. Resonator (1) nach Anspruch 9 oder 10, **dadurch gekennzeichnet, dass** die zweite Auflage (5) einen thermoelastischen Koeffizienten aufweist, der in zweiter Ordnung positiv ist.

12. Resonator (1) nach dem vorhergehenden Anspruch, **dadurch gekennzeichnet, dass** die zweite Auflage (5) einen thermoelastischen Koeffizienten aufweist, der in erster Ordnung positiv ist.

13. Resonator (1) nach dem vorhergehenden Anspruch, **dadurch gekennzeichnet, dass** die zweite Auflage (5) Germaniumdioxid enthält.

14. Resonator (1) nach Anspruch 11, **dadurch gekennzeichnet, dass** die zweite Auflage (5) einen thermoelastischen Koeffizienten aufweist, der in erster Ordnung negativ ist.

**15.** Zeitmessgerät, **dadurch gekennzeichnet, dass** es mindestens einen Resonator nach einem der vorhergehenden Ansprüche umfasst.

**Claims**

**1.** Temperature compensated resonator (1) of the tuning fork type including a body formed of at least two symmetrically mounted bars and used in deformation, the core (3) of the body including a first material, the body including a first coating (4) made of a second material, **characterized in that** the body includes at least a second coating (5) made of a third material, the thermoelastic coefficients of each material being different, each thickness of said at least a first and a second coating being adjusted to permit substantially zero first and second order ($\alpha$, $\beta$) temperature coefficients of frequency of said resonator (1).

**2.** Temperature compensated resonator (1) of the sprung balance type comprising a body including a bar wound around itself forming a balance spring, coupled with an inertia flywheel and used in deformation, the core (3) of the body including a first material, the body including a first coating (4) made of a second material, **characterized in that** the body includes at least a second coating (5) made of a third material, the thermoelastic coefficients of each material being different, each thickness of said at least a first and a second coating being adjusted to permit substantially zero first and second order ($\alpha$, $\beta$) temperature coefficients of frequency of said resonator (1).

**3.** Temperature compensated resonator (1) of the MEMS type including a body used in deformation, the core (3) of the body including a first material, the body including at least a first and a second coating (4, 5) respectively made of a second and a third material, the thermoelastic coefficients of each material being different, **characterized in that** each thickness of said at least a first and a second coating is adjusted to permit substantially zero first and second order ($\alpha$, $\beta$) temperature coefficients of frequency of said resonator (1).

**4.** Resonator (1) according to claim 1, 2 or 3, **characterized in that** the body includes a third coating made of a fourth material wherein the thermoelastic coefficients of each material are different, each thickness of said three coatings being adjusted to permit substantially zero first, second and third order ($\alpha$, $\beta$, $\gamma$) temperature coefficients of said resonator (1).

**5.** Resonator (1) according to any of the preceding claims, **characterized in that** the core (3) of the body has negative first and second order thermoelastic coefficients.

**6.** Resonator (1) according to the preceding claim, **characterized in that** the core (3) of the body includes single crystal silicon.

**7.** Resonator (1) according to any of the preceding claims, **characterized in that** the body includes a substantially quadrilateral-shaped section with pairs of identical faces.

**8.** Resonator (1) according to any of claims 1 to 6, **characterized in that** the body includes a substantially quadrilateral-shaped section whose faces are entirely coated.

**9.** Resonator (1) according to any of the preceding claims, **characterized in that** first coating (4) has positive first order and negative second order thermoelastic coefficients.

**10.** Resonator (1) according to the preceding claim, **characterized in that** the first coating (4) includes silicon dioxide.

**11.** Resonator (1) according to claim 9 or 10, **characterized in that** the second coating (5) has a positive second order thermoelastic coefficient.

**12.** Resonator (1) according to the preceding claim, **characterized in that** the second coating (5) has a positive first order thermoelastic coefficient.

**13.** Resonator (1) according to the preceding claim, **characterized in that** the second coating (5) includes germanium dioxide.

**14.** Resonator (1) according to claim 11, **characterized in that** the second coating (5) has a negative first order thermoelastic coefficient.

15. Timepiece **characterized in that** the timepiece includes at least one resonator according to any of the preceding claims.

Fig. 1

Fig. 2

Fig. 3

Fig. 4

Fig. 5

Fig. 6

Fig. 7

Fig. 8

Fig. 9

**EP 2 514 094 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1422436 A
- WO 2008043727 A
- WO 2007072409 A